Europäisches Patentamt

European Patent Office

Office européen des brevets

(11) Publication number: **0 405 458 A2**

# EUROPEAN PATENT APPLICATION

(21) Application number: 90112148.3

(51) Int. Cl.⁵: **G11C 16/02**

(22) Date of filing: 26.06.90

(30) Priority: 26.06.89 JP 163198/89

(43) Date of publication of application:
02.01.91 Bulletin 91/01

(84) Designated Contracting States:
**DE FR GB**

(71) Applicant: **Kabushiki Kaisha Toshiba**
**72, Horikawa-cho Saiwai-ku**
**Kawasaki-shi(JP)**

(72) Inventor: **Araki, Hitoshi, c/o Intellectual**
**Property Division**
**Kabushiki Kaisha Toshiba 1-1 Shibaura**
**1-chome**
**Minato-ku Tokyo 105(JP)**

(74) Representative: **Lehn, Werner, Dipl.-Ing. et al**
**Hoffmann, Eitle & Partner Patentanwälte**
**Arabellastrasse 4e 4**
**D-8000 München 81(DE)**

(54) Ultraviolet-erasable type non-volatile semiconductor memory device having multilayered wiring structure.

(57) A non-volatile semiconductor memory device comprises memory cells (MC1, MC2) consisting of MOS transistors of a floating gate structure. Data stored in the memory cells is erasable by means of irradiation of ultraviolet rays. Insulating layer (21) is formed above the memory cells (MC1, MC2). Wiring layer (23) is formed on insulating layer (21). Wiring layer (23) is formed substantially parallel to control gate electrode (17a, 17b) which extends horizontally at right angles and has a width ($\Delta$W) greater than the width ($\Delta$Wa, $\Delta$Wb) of control gate electrode (17a, 17b). A least one of opposing sides of wiring layer (23) which extend horizontally and at right angles to the channel is located on said floating gate electrode (15a, 15b) or on the extension lines (100a, 100b) drawn from one of opposing sides of said floating gate electrode (15a, 15b) which extend horizontally and at right angles to the channel.

F I G. 2

# ULTRAVIOLET-ERASABLE TYPE NON-VOLATILE SEMICONDUCTOR MEMORY DEVICE HAVING MULTI-LAYERED WIRING STRUCTURE

This invention relates to an ultraviolet-erasable type non-volatile semiconductor memory device, and more particularly to a non-volatile semiconductor memory device having a multilayered wiring structure which suppresses the degradation of data-erasure characteristic.

In recent years, semiconductor devices have been highly integrated and functionally improved. To increase the integration density and achieves further functional improvement, it is necessary to make elements finer. A multilayered wiring structure, in which various wiring layers are arranged three-dimensionally, is also an effective measure for this purpose.

An ultraviolet-erasable type non-volatile semiconductor memory device (hereinafter referred to as EPROM) is known as one of the non-volatile semiconductor memory devices. In the EPROM also, the multilayered wiring structure greatly helps to increase the integration density and accomplish functional improvement. However, some problems arise when the multilayered wiring structure is applied to an EPROM, since the data stored in the EPROM is erased by applying ultraviolet rays to the EPROM. One of the problems will be now described in detail.

The data-erasure characteristic (erasure time) of an ultraviolet-erasable type EPROM depends on the amount of ultraviolet rays applied to the floating gate of each EPROM cell. The ultraviolet rays (wavelength of about 2500 Å), which are effective for erasing data stored in EPROMs, pass through silicon oxide, but are reflected by metal, e.g. aluminum. The ultraviolet rays are reflected or absorbed by silicon, and reach only to about 50 Å depth. Thus, the ultraviolet rays are reflected or absorbed by aluminum and polysilicon, which are generally used as wiring material since they can be processed into fine elements and have good ohmic characteristic with respect to semiconductors. Hence, if the multilayered wiring used in an EPROM is formed of aluminum and polysilicon, it reflects or absorbs ultraviolet rays; only a small amount of ultraviolet rays is applied to the floating gate of each EPROM cell. As a result, it takes a long period of time to erase the data stored in the cell.

The above-mentioned problem is more serious in a highly integrated EPROM, since the floating gate of each EPROM cell is narrow. In the multilayered wiring structure, an upper wiring layer must be wide, since it is more rugged, and would otherwise be cut easily. Hence, the wiring layer may be wider than the floating gate and cover the fine floating gate. The ultraviolet rays which are applied to the sides of the floating gate, especially those portions near the control gate and the diffusion layer, are known as effective data-erasing rays. For this reason, in a cell in which the control gate and the floating gate are self-aligned, ultraviolet rays applied to those sides of the floating gate which are at right angle to the channel are a prominent determinant of erase operation.

As described above, in a conventional EPROM cell having a multilayered wiring structure, when ultraviolet rays irradiate very little or do not irradiate the floating gate of each EPROM cell (especially the sides thereof), the data-erasure characteristic is degraded, inevitably prolonging the erasure operation or making it impossible to erase data.

It is accordingly an object of the present invention to provide an ultraviolet-erasable type non-volatile semiconductor memory device having a multilayered wiring structure in which the data-erasure characteristic is not significantly degraded or the same as compared to a memory device not having a multilayered wiring structure.

The object is achieved by an ultraviolet-erasable type non-volatile semiconductor memory device comprising: a semiconductor body of a first conductivity type; source and drain regions of a second conductivity type formed in a main surface region of the semiconductor body at a predetermined distance; a first insulating film formed on a channel region between the source and drain regions; a first gate electrode, formed on the first insulating film, brought into an electrically floating state and serving as a floating gate; a second insulating film formed on the first gate electrode; a second gate electrode formed on the second insulating film and serving as a control gate; a third insulating film formed on the second gate electrode; and a wiring layer formed on the third insulating film substantially parallel to opposing sides of the second electrode which extends horizontally and at right angles to channel, the wiring layer being wider than the second gate electrode, at least one of opposing sides of the wiring layer which extend horizontally and at right angles to the channel being arranged on or a position above the first gate electrode and the extension line drawn from one of the opposing sides of the first gate electrode which extend horizontally and at right angles to the channel, and drawn perpendicular to the surface of the semiconductor body.

With this structure, one of opposing sides of the wiring layer is arranged on a position above the first gate electrode or on the extension line drawn from one of the sides of the floating gate which extends horizontally and at right angles to the channel. Hence, even if a wiring layer is formed above the floating gate substantially in parallel with the control gate, ultraviolet rays can be applied to said sides of the floating gate. Therefore, according to the present invention, there is provided an ultraviolet-erasable type non-volatile semiconductor memory device having a multilayered wiring structure in which the data-erasure characteristic is not significantly degraded or the same as compared to a memory device not having a multilayered wiring structure.

This invention can be more fully understood from the following detailed description when taken in conjunction with the accompanying drawings, in which:

Fig. 1 is a plan view showing a pattern of memory cells of an ultraviolet-erasable type non-volatile semiconductor memory device according to a first embodiment of the present invention;

Fig. 2 is a cross-sectional view taken along line A-A' of the pattern shown in Fig. 1;

Fig. 3 is a cross-sectional view taken along line B-B' of the pattern shown in Fig. 1;

Fig. 4 is a plan view showing a pattern of memory cells of an ultraviolet-erasable type non-volatile semiconductor memory device according to a second embodiment of the present invention;

Fig. 5 is a cross-sectional view taken along line C-C' of the pattern shown in Fig. 4;

Fig. 6 is a cross-sectional view taken along line D-D' of the pattern shown in Fig. 4;

Fig. 7 is a plan view showing a pattern of memory cells of an ultraviolet-erasable type non-volatile semiconductor memory device according to a third embodiment of the present invention;

Fig. 8 is a cross-sectional view taken along line E-E' of the pattern shown in Fig. 7:

Fig. 9 is a cross-sectional view taken along line F-F' of the pattern shown in Fig. 7;

Fig. 10 is a plan view showing a pattern of memory cells of an ultraviolet-erasable type non-volatile semiconductor memory device according to a fourth embodiment of the present invention;

Fig. 11 is a cross-sectional view taken along line G-G' of the pattern shown in Fig. 10;

Fig. 12 is a cross-sectional view taken along line H-H' of the pattern shown in Fig. 10;

Fig. 13 is a plan view showing a pattern of memory cells of an ultraviolet-erasable type non-volatile semiconductor memory device according to a fifth embodiment of the present invention;

Fig. 14 is a cross-sectional view taken along line I-I' of the pattern shown in Fig. 13; and

Fig. 15 is a cross-sectional view showing memory cells of an ultraviolet-reasable type semiconductor memory device according to a sixth embodiment of the present invention.

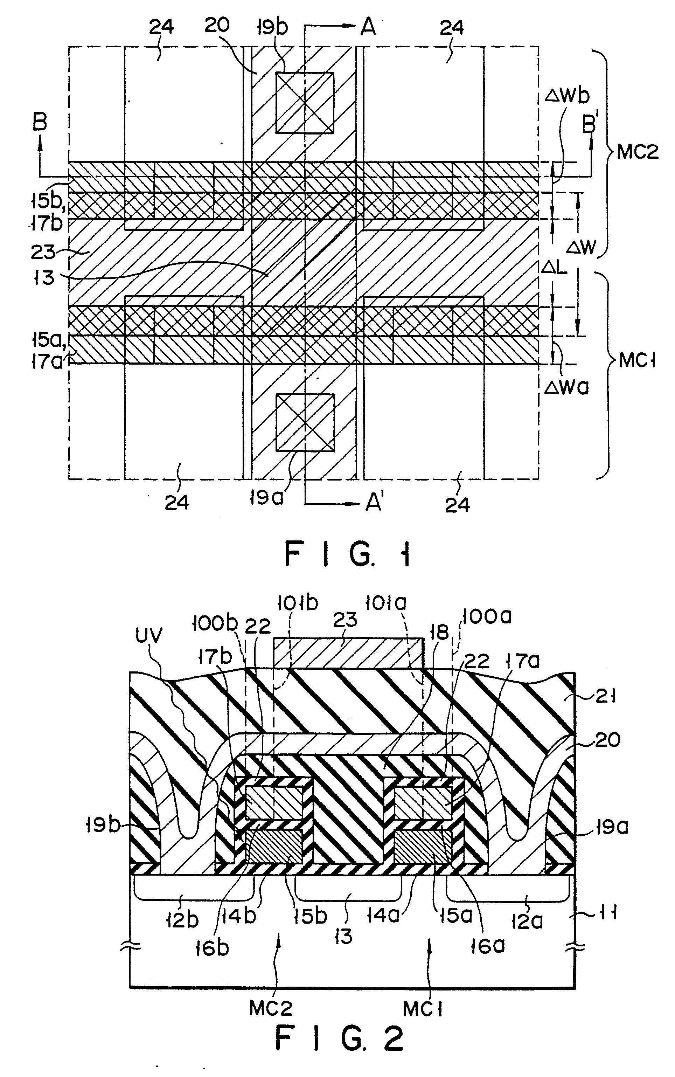

Figs. 1 to 3 are a plan view and cross-sectional views showing a pattern of memory cells in the ultraviolet-erasable type non-volatile semiconductor memory device according to a first embodiment of the present invention. In these drawings, two adjacent memory cells MC1 and MC2 are illustrated as representatives of a memory cell array. In the main surface region of semiconductor substrate 11 of a first conductivity type (e.g. p-type), drain regions 12a and 12b and source region 13 of a second conductivity type (n-type) are formed at predetermined distances. Source region 13 is used in common by memory cells MC1 and MC2. Field oxide film 24 serving as an element isolating region is selectively formed on substrate 11. In the element regions isolated by field oxide film 24, gate oxide films 14a and 14b are respectively formed on channel regions between drain region 12a and source region 13 and between source region 13 and drain region 12b. Floating gates 15a and 15b are formed on gate oxide films 14a and 14b, respectively. Insulating films (e.g. thermal oxide films) 16a and 16b are formed on floating gates 15a and 15b and electrically isolates floating gates 15a and 15b from control gates 17a and 17b. Control gates (word lines) 17a and 17b are formed on thermal oxide films 16a and 16b, respectively. Further, thermal oxide film 22 is formed on the upper and side surfaces of control gates 17a and 17b and side surfaces of floating gates 15a and 15b. On the resultant structure, BPSG film 18 serving as an interlayer insulating film is formed so as to flatten the surface. In BPSG film 18, contact holes 19a and 19b are respectively formed at positions corresponding to drain regions 12a and 12b. Bit line 20 made of a first aluminum layer, for example, is connected to drain regions 12a and 12b via contact holes 19a and 19b, respectively. Bit line 20 extends horizontally and substantially perpendicular to control gates 17a and 17b. Insulating film 21 is formed on bit line 20 and interlayer insulating film 18. On insulating film 21, wiring layer 23 made of a second aluminum layer, for example, is formed substantially parallel to control gates 17a and 17b. As shown in Fig. 2, wiring layer 23 is formed between lines 100a and 100b, each of which is extended from one of the sides of each of floating gates 15a and 15b and drawn perpendicular to the surface of semiconductor substrate 11. In other words, at least one of opposing sides of each of floating gate 15a and 15b, which extend horizontally and at right angles to the channel (hereinafter referred to as "sides" of the floating gates), is located outside an area between lines 101a and 101b, which are extended from the sides of wiring layer 23 parallel to said sides of floating gates 15a and 15b. Thus, looking at the plan view of the memory cell portion, as shown in Fig. 1, wiring layer 23 is formed so as not to cover at least one of said sides of each of floating gates 15a and 15b. Wiring layer 23 serves as a signal line for supplying a signal from the main decoder to the section decoder, in a case where a decoder is constituted by a main decoder and a section decoder and decoding is performed in two stages.

In the memory device thus arranged, since wiring layer 23 does not prevent the ultraviolet irradiation to the floating gate, even in a multilayered wiring structure in which wiring layer 23 is formed substantially parallel to control gates 17a and 17b, ultraviolet rays can sufficiently be applied to said sides of floating gates 15a and 15b. Hence, the erasure characteristic is not significantly reduced or the same as compared to the memory cell not having a multilayered wiring structure. Needless to say, the integration density of the entire semiconductor memory device can be increased and function thereof can be improved as compared to the memory device not having memory cells of a multilayered wiring structure.

In the above-described embodiments, wiring layer 23 overlies control gates 17a and 17b. The distance between control gates 17a and 17b becomes shorter as the elements becomes finer, i.e, the integration density of the memory device is increased. The present invention aims at high integration and functional improvement of a semiconductor device by both a multilayered wiring structure of an EPROM and minute formation of elements, and produces a preferable result especially when the distance $\Delta L$ between control gates 17a and 17b is 1.2 $\mu$m, or shorter. In the memory device shown in Figs. 1 to 3, assuming that the distance $\Delta L$ between control gates 17a and 17b is 1.2 $\mu$m, the width $\Delta W$ of wiring layer 23 is 2 $\mu$m, and the widths $\Delta Wa$ and $\Delta Wb$ are 1 $\mu$m, it is certain that wiring layer 23 is formed between lines 100a and 100b extended from of the sides of floating gates 15a and 15b with the current lithography accuracy.

To prevent degradation of the data-erasure characteristic, wiring layer 23 may be narrower as the memory cell becomes minute. However, in this case, a narrow wiring layer may be cut easily and the reliability of the wiring layer may be reduced. Thus, decrease of the width of wiring layer 23 is not a desirable measure. In contrast, according to the present invention, satisfactory data-erasure characteristic can be maintained without decreasing the width $\Delta W$ of wiring layer 23.

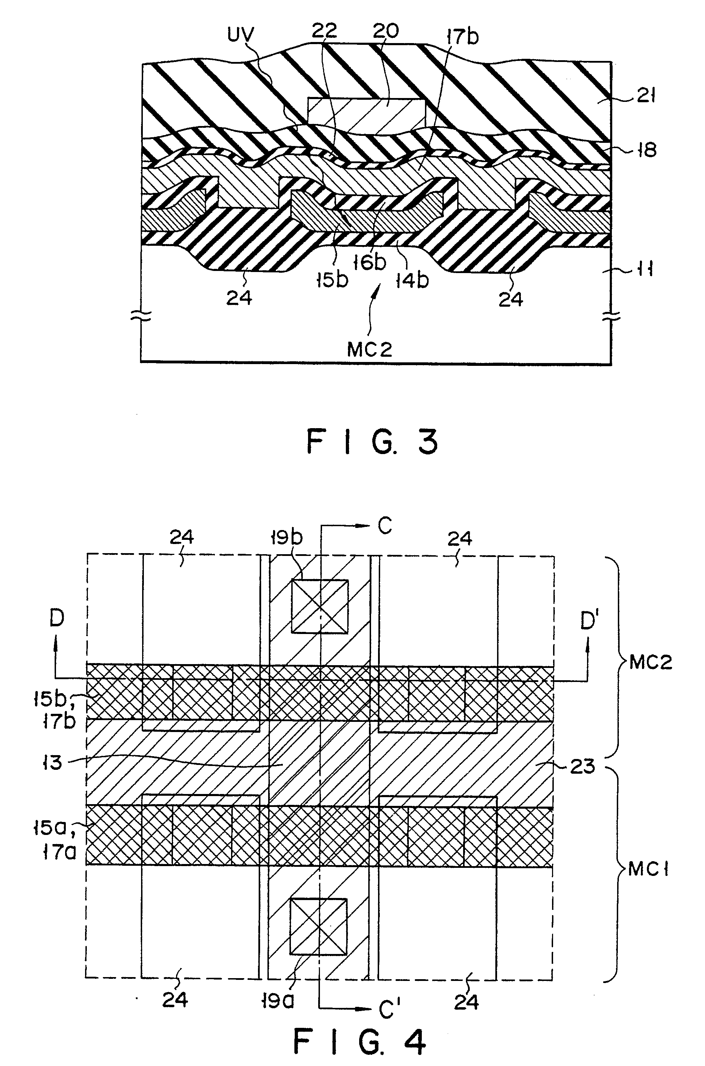

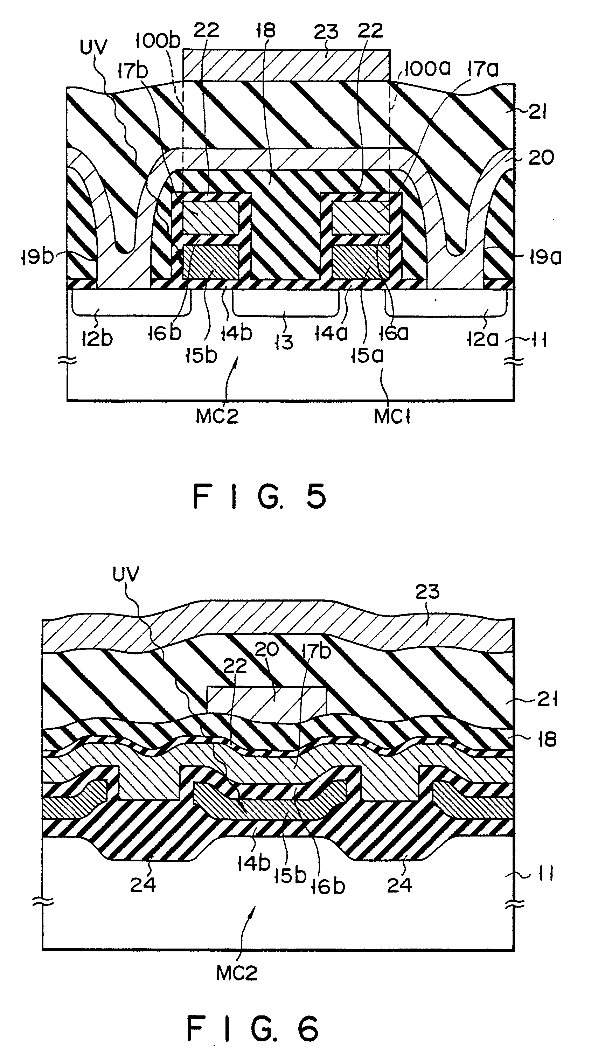

In the first embodiment as described above, the sides of wiring layer 23, which are parallel to the sides of floating gates 15a and 15b, are located above control gates 17a and 17b (i.e., above floating gates 15a and 15b). However, said sides of wiring layer 23 may be located on lines 100a and 100b, each of which are extended from one of the sides of each of floating gates 15a and 15b, as shown in Figs 4 to 6 (second embodiment). In Figs. 4 to 6, the same reference numerals as in Figs. 1 to 3 are assigned to the components identical with those shown in Figs. 1 to 3. Hence, the description of these components are omitted.

Also in the second embodiment, wiring layer 23 does not interfere with ultraviolet irradiation, with the same effect as in the first embodiment.

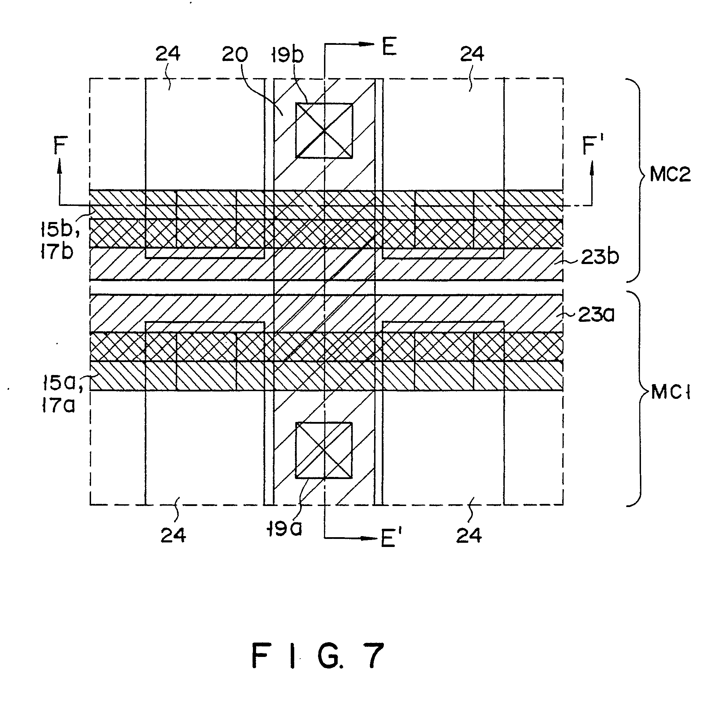

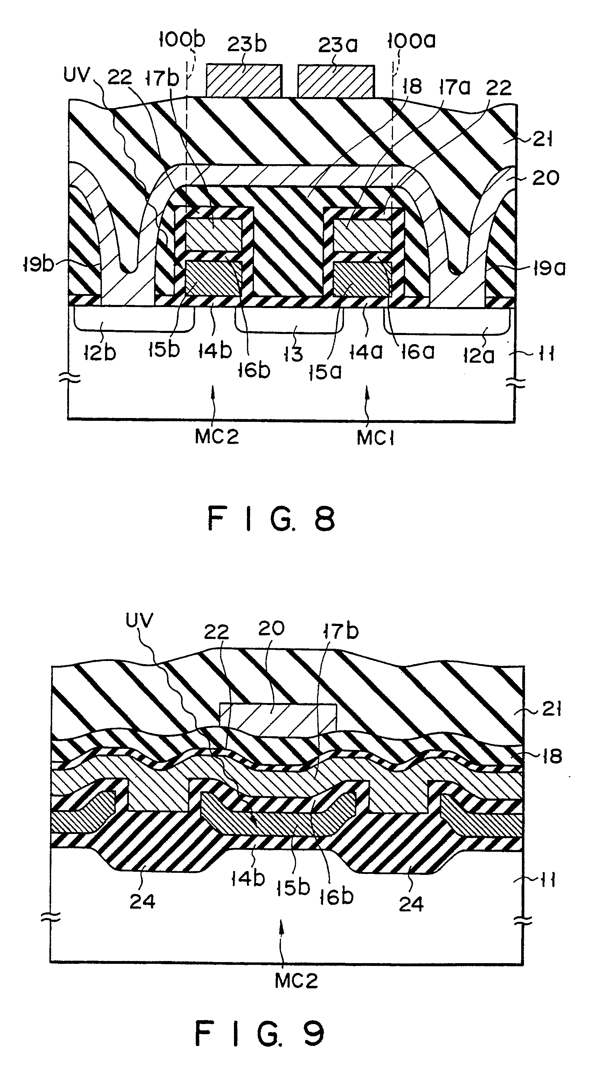

In the above-described first and second embodiments, wiring layer 23 overlies control gates 17a and 17b (over floating gates 15a and 15b) of adjacent memory cells MC1 and MC2. However, this invention is not limited to such a structure. As shown in Figs. 7 to 9, wiring layers 23a and 23b may be formed respectively above control gates 17a and 17b (above floating gates 15a and 15b) of memory cells MC1 and MC2 (third embodiment).

Also in the third embodiment, so long as at least one of the sides of each of wiring layers 23a and 23b, which are parallel to the sides of floating gates 15a and 15b, is located on extension line 100a or 100b (drawn from the sides of the floating gates and perpendicular to the surface of the substrate 11), or between extension lines 100a and 100b, the same effect as in the first and second embodiments can be obtained.

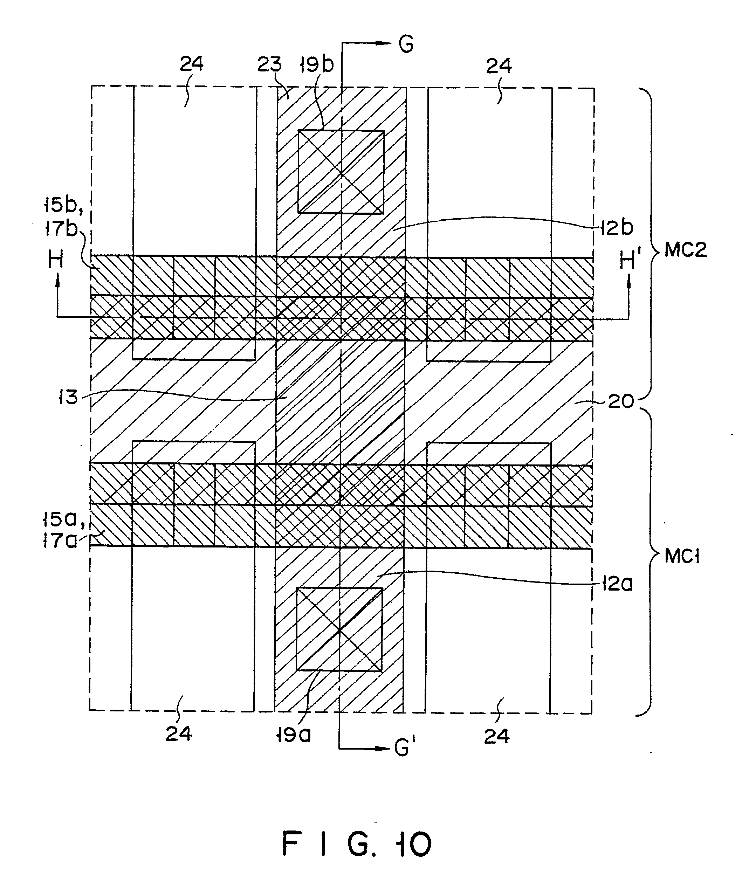

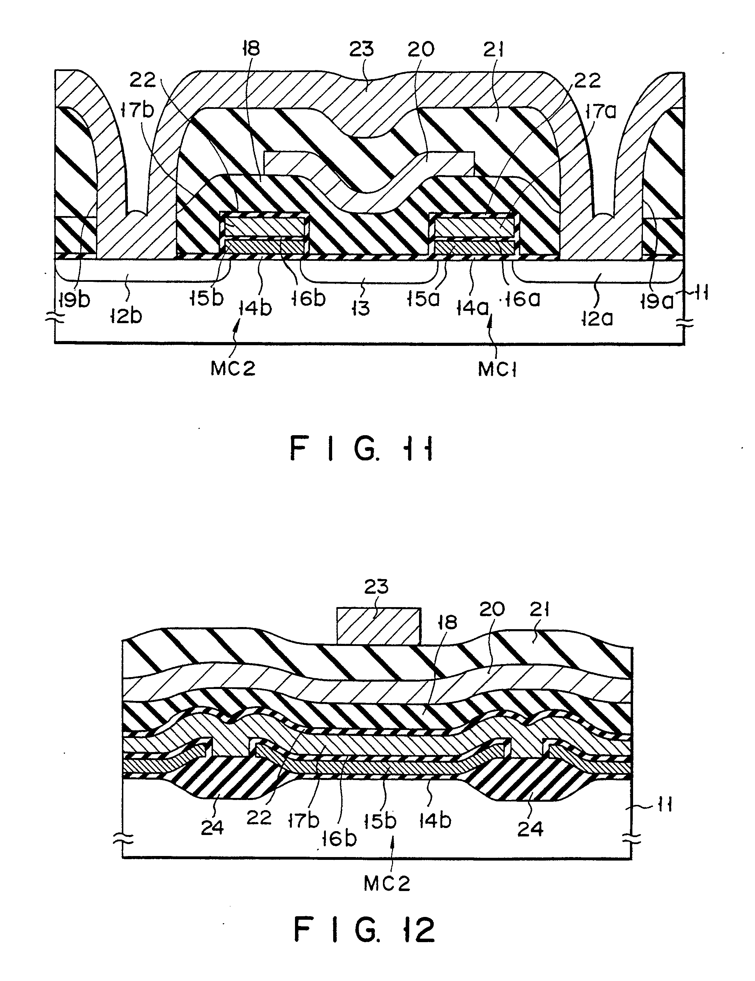

In the above-described first to third embodiments, first wiring layer 20 is formed substantially perpendicular to control gates 17a and 17b, and second wiring layer 23 is formed substantially parallel to control gates 17a and 17b. However, as shown in Figs. 10 to 12, first wiring layer 20 may be formed substantially parallel to control gates 17a and 17b, and second wiring layer 23 may be formed substantially at right angles to control gates 17a and 17b (fourth embodiment). Also in the fourth embodiment, the same effect as in the first to third embodiments can be obtained. Wiring layer 23 in the fourth embodiment serves as a bit line, and wiring layer 20 serves as wiring layer 23 in the first to third embodiments.

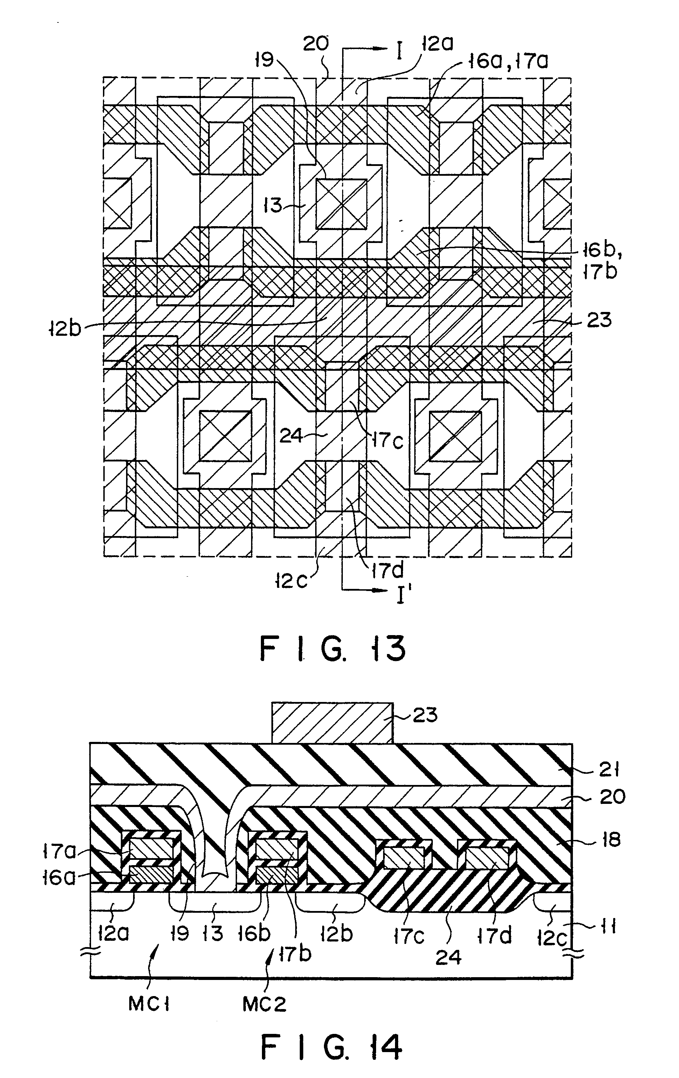

The plane pattern of the memory cell portion is not limited to the arrangements as in the above-described embodiments. The memory cells may be arranged in a staggered fashion as shown in Figs. 13 and 14 (fifth embodiment). The basic structure of the plane pattern of a memory cell array arranged in a staggered fashion (not having a multilayered wiring structure) is disclosed in "1990 IEEE International Solid-State Circuits Conference DIGEST OF TECHNICAL PAPERS pp. 58 and 59, Session 4: Non-Volatile and Fast Static Memories" written by the inventor and others. The contents of this document are incorporated into this invention.

In Fig. 14, control gates 17c and 17d formed on field oxide film 24 extend toward an adjacent memory cell, and source region 12c is included in another adjacent memory cell.

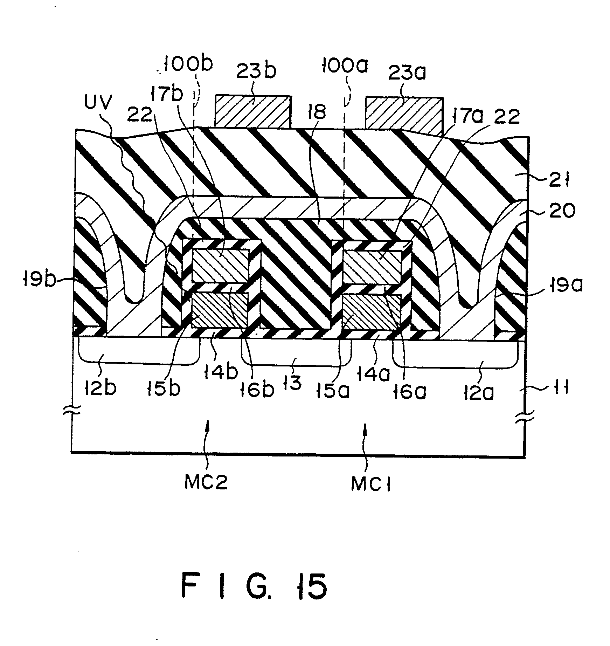

In the third embodiment, two wiring layers 23a and 23b are formed between extension lines 100a and 100b. However, needless to say, wiring layers 23a and 23b may be arranged as shown in Fig. 15.

As has been described above, according to the present invention, data erase characteristic is not degraded, i.e. the same erasure characteristic as in prior art is obtained, even if a multilayered wiring structure is applied to an ultraviolet-erasable type non-volatile semiconductor memory device.

Reference signs in the claims are intended for better understanding and shall not limit the scope.

**Claims**

1. An ultraviolet-erasable type non-volatile semiconductor memory device including a memory cell comprising a semiconductor body (11) of a first conductivity type, source region (13) and drain regions (12a, 12b) of a second conductivity type formed in a main surface region of said semiconductor body at a predetermined distance, a first insulating film (14a, 14b) formed on a channel region between said source and drain regions (13, 12a, 12b), a first gate electrode (15a, 15b) formed on said first insulating film (14a,14b), brought into an electrically floating state and serving as a floating gate, a second insulating film (16a, 16b) formed on said first gate electrode (15a, 15b) a second gate (17a, 17b) electrode formed on said second insulating film (14a, 14b), and serving as a control gate, and a third insulating film (21) formed on said second gate electrode (17a, 17b), said memory device characterized by further comprising: a wiring layer (23) formed on said third insulating film (21) substantially parallel to opposing sides of said second electrode (17a, 17b) which extend horizontally and at right angles to the channel, said wiring layer being wider than the second gate electrode (17a, 17b), at least one of opposing sides of said wiring layer (23) which extend horizontally and at right angles to the channel being arranged on one of a position above said first gate electrode and the extension line (100a, 100b) of one of the opposing sides of said first gate electrode (15a, 15b) which extend horizontally and at right angles to the channel, drawn perpendicular to the surface of the semiconductor substrate.

2. An ultraviolet-erasable type non-volatile semiconductor memory device of the having a memory cell array in which memory cells are arranged in matrix, each of said memory cells comprising a semiconductor substrate (11) of a first conductivity type, source region (13) and drain regions (12a, 12b) of a second conductivity type formed on the main surface region of said semiconductor substrate (11), a first insulating film (14a, 14b) formed on a channel region between said source region (13) and drain regions (12a, 12b), a first gate electrode (15a, 15b) formed on said first insulating film (14a, 14b), brought into an electrically floating state and serving as a floating gate, a second insulating film (16a, 16b) formed on said first gate electrode (15a, 15b), a second gate electrode (17a, 17b) formed on said second insulating film (16a, 16b) and serving as a control gate, and a third insulating film (21) formed on said second gate electrode (17a, 17b), said memory device characterized by further comprising: a wiring layer (23) formed on said third insulating film (21) substantially parallel to opposing sides of said second electrode (17a, 17b) which extend horizontally and at right angles to the channel, said wiring layer being wider than the second gate electrode (17a, 17b), said wiring layer (23) being formed above the region between two adjacent second gate electrodes arranged at an interval of 1.2 μm at most, at least one of opposing sides of said first gate electrode (15a, 15b) which extend horizontally and at right angles to the channel being arranged outsides the region between the extension lines (101a, 101b) drawn from of the opposing sides of said wiring layer (23) which extend at right angles to the channel, and drawn perpendicular to the surface of the semiconductor substrate (11).

3. A device according to claim 1 or 2, characterized in that said source region (13) is used in common by two adjacent memory cells (MC1, MC2).

4. A device according to claim 1, characterized in that a distance between the second gate electrode (17a) and the second gate electrode (17b) of adjacent memory cells is 1.2 μm at most.

5. A device according to claim 1, characterized in that said wiring layer (23) overlies two adjacent memory cells (MC1, MC2).

6. A device according to claim 1 or 2, characterized by further comprising a fourth insulating film (22, 18) and a second wiring layer (20) formed between said second gate electrode (17a, 17b) and said third insulating film (21), said second wiring layer (20) extends at right angles to said second gate electrode (17a, 17b).

7. A device according to claim 6, characterized in that said second wiring layer (20) extends at right angles to said wiring layer (23).

8. A device according to claim 7, characterized in that said second wiring layer (20) serves as a bit line and is connected to said drain region (12a, 12b).

F I G. 1

F I G. 2

7

F I G. 3

F I G. 4

# F I G. 5

# F I G. 6

F I G. 7

F I G. 8

F I G. 9

F I G. 10

F I G. 11

F I G. 12

F I G. 13

F I G. 14

F I G. 15